(19) Europäisches Patentamt
European Patent Office
Office européen des brevets

(11) **EP 2 372 384 A1**

(12) **EUROPÄISCHE PATENTANMELDUNG**

(43) Veröffentlichungstag:
**05.10.2011 Patentblatt 2011/40**

(51) Int Cl.:
**G01R 33/561** (2006.01)

(21) Anmeldenummer: **10158005.8**

(22) Anmeldetag: **26.03.2010**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**AL BA ME RS**

(71) Anmelder: **Universitätsklinikum Freiburg**
**78106 Freiburg (DE)**

(72) Erfinder: **Leupold, Jochen**
**79114 Freiburg (DE)**

(74) Vertreter: **Kohler Schmid Möbus**
**Patentanwälte**
**Ruppmannstraße 27**
**70565 Stuttgart (DE)**

(54) **Verfahren zur Erhöhung der Spoileffizienz in der magnetischen Resonanz**

(57) Ein Verfahren zum Betrieb eines Kernspintomographen, wobei eine kontinuierliche Folge von Hochfrequenz- (=HF) Pulsen auf eine Probe eingestrahlt wird, wobei $\Psi$ konstanter Phasenwert für alle Magnetisierungsvektoren ist, wobei alle Magnetisierungsvektoren während des n-ten Sequenzintervalls einen Phasenfortschritt $F_n = n\Psi$ erfahren, wobei P die Zahl der HF-Pulse ist, nach der sich die Phasenlage der Magnetisierungsvektoren wiederholt, wobei das totale Gradientenmoment in eine oder mehrere Raumrichtungen einen Wert größer 0 aufweist, wobei aufeinanderfolgende Pulse den konstanten zeitlichen Abstand TR aufweisen und wobei nach der Einstrahlung eines HF-Pulses eine k-Raum-Zeile aufgenommen wird, ist dadurch gekennzeichnet, dass eine beliebige ein- oder mehrdimensionale Anordnung von k-Raum-Zeilen N mal identisch wiederholt wird, und dass Signale von identischen k-Raum-Zeilen gemittelt oder addiert werden. Mit diesem Verfahren wird die Effizienz des Gradientenspoilings und somit die Effizienz der Artefakt-Unterdrückung erhöht.

Fig. 2

EP 2 372 384 A1

**Beschreibung**

Hintergrund der Erfindung

Die Erfindung betrifft ein Verfahren zum Betrieb eines Kernspintomographen, wobei eine kontinuierliche Folge von Hochfrequenz- (=HF) Pulsen auf eine Probe eingestrahlt wird, wobei Ψ konstanter Phasenwert für alle Magnetisierungsvektoren ist, wobei alle Magnetisierungsvektoren während des n-ten Sequenzintervalls einen Phasenfortschritt $F_n = n\Psi$ erfahren, wobei P die Zahl der HF-Pulse ist, nach der sich die Phasenlage der Magnetisierungsvektoren wiederholt, wobei das totale Gradientenmoment in eine oder mehrere Raumrichtungen einen Wert größer 0 aufweist, wobei aufeinanderfolgende Pulse den konstanten zeitlichen Abstand TR aufweisen und wobei nach der Einstrahlung eines HF-Pulses eine k-Raum-Zeile aufgenommen wird.

Eine solches Verfahren ist durch Denolin et al. [1] bekannt.

Eine Hochfrequenz(HF)-gespoilte Gradientenechosequenz (im Folgenden auch FLASH genannt) wird durch folgende Merkmale bestimmt [1-5]:

- Es wird eine kontinuierliche Folge von Hochfrequenzen auf die Probe (wie etwa einen Menschen) eingestrahlt, wobei aufeinanderfolgende Pulse den konstanten zeitlichen Abstand TR aufweisen.

- Nach der **HF**-Einstrahlung werden Magnetfeldgradienten angelegt, wodurch der interessierende Ortsraum einem Ortsfrequenzraum äquivalent wird, dessen inverse Fouriertransformierte der k-Raum, mit beliebiger Dimension, ist. Als zusätzliche Dimension lässt sich bei der Aufnahme die Zeit t einführen, wodurch der k-t-Raum aufgenommen wird.

Nach jedem **HF**-Puls wird eine Zeile des k-t-Raumes aufgenommen, wobei eine Zeile eine Menge von Punkten im k-t-Raum darstellt, die auf einer Geraden in beliebiger Richtung im k-t-Raum liegen. Das nach einem RF-Puls akquirierte Signal des k-t-Raumes wird als "k-Raum-Zeile" bezeichnet.

[0005] - Jeder Magnetisierungsvektor $M(\theta) = (M_x, M_y, M_z)$ erhält während des n-ten Sequenzintervalls einen Phasenfortschritt $n \cdot \psi$ wobei n die Pulsnummer ist und ψ ein konstanter Phasenwinkel (in Grad oder rad) ist, das "Spoilinkrement" [2]. Zwischen den transversalen Magnetisierungsvektoren $\mathbf{M}_n^+(\theta) = M_{x,n}^+ + iM_{y,n}^+$ *unmittelbar* nach Puls Nr. n und

$\mathbf{M}_{n+1}^-(\theta) = M_{x,n+1}^- + iM_{y,n+1}^-$ unmittelbar vor Puls Nr. n+1 gilt also die Beziehung $\mathbf{M}_{n+1}^-(\theta) = \mathbf{M}_n^+(\theta)e^{in\psi}$ .

Dieser Phasenfortschritt wird üblicherweise dadurch realisiert dass die HF-Pulse mit einer Phase $\varphi_n = n(n-1)\psi/2$ versehen werden.

- während eines Sequenz-Zyklusses mit der Dauer TR weist das totale Gradientenmoment

$$m_{\text{tot}} = \int_{t'}^{t'+TR} G(t)dt \qquad \{1\}$$

(G(t) = der zeitliche Verlauf des Gradienten, t' = ein beliebig gewählter Zeitpunkt während eines Repetitionsintervalls) in eine oder mehrere Raumrichtungen einen Wert größer null auf ("Spoilergradient"), so dass vor Beginn des folgenden HF-Pulses die Magnetisierung in einem Voxel entlang der Richtung des Spoilergradienten einen variierenden Phasenwinkel aufweist. Die Summe über alle Magnetisierungsvektoren in einem Voxel führt dazu, dass Artefakte, die durch den variierenden HF-Puls-Phasenwinkel verursacht werden, verhindert werden [5].

HF-gespoilte Gradientenechosequenzen wurden entwickelt, da die resultierenden Bilder bei geeigneter Wahl von ψ einen reinen T1-Kontrast zeigen [1, 3]. Nach einigen Sequenzzyklen gilt für den Magnetisierungsvektor direkt nach dem n+1-ten HF-Puls [4, 6]

$$M^+_{n+1}(\theta) = M^+_n(\theta+\psi) \qquad \{2\}$$

worin ψ das Spoilinkrement der HF-Pulsphase darstellt und θ den Phasenwinkel, um den die einzelnen Magnetisierungsvektoren während TR aufgrund des Spoilergradienten weiterlaufen. Die Gesamtheit der Magnetisierungsvektoren, die den gleichen Winkel θ erfahren, bildet dann eine Isochromate. Gleichung {2} lässt sich so interpretieren, dass sich nach jedem HF-Puls die Zuordnung des Magnetisierungsvektors einer bestimmten Isochromate zu einem gegebenen Profil M ändert.

Außerdem gilt

$$\mathbf{M}^+_{n+P}(\theta) = \mathbf{M}^+_n(\theta + P\psi) = \mathbf{M}^+_n(\theta) \qquad \{3\}$$

wenn gilt

$$P\cdot\psi = K\cdot 2\pi, \qquad\qquad \{4\}$$

wobei P und K ganze Zahlen sind. P ist dabei die Periode (die Zahl der HF-Pulse) nach der sich die Zuordnung des Magnetisierungsprofils zu den einzelnen Isochromaten wiederholt.

Die Funktion für den Magnetisierungsvektor ist $2\pi$-periodisch in θ und es gilt:

$$\int_{-\pi}^{\pi} M_n^+(\theta)\mathrm{d}\theta = \mathrm{const.} \qquad \{5\}$$

Wegen des Verhaltens gemäß {2} und {5} nennt man den Zustand, den das FLASH Signal einnimmt, einen "pseudo steady state".

Entsprechend der Amplitude G (in T/m) und Dauer *t* des Spoilergradienten liegt nach Ende des Gradienten über eine Strecke *s* ein Phasenunterschied der Magnetisierung von

$$\Delta\theta = 2\pi\cdot\gamma\cdot s\cdot\int G(t)dt \qquad \{6\}$$

vor (y ist das gyromagnetische Moment in Hz/T).

Das "Spoilmoment" $m_{sp}$ des Spoilergradienten gibt an, welche Phasendifferenz $\Delta\theta$ über eine Voxellänge x in Gradientenrichtung auftritt:

$$m_{sp} = 2\pi\cdot\gamma\cdot x\cdot\int G(t)dt \qquad \{7\}$$

Bei $m_{sp} = 2\pi$ läuft das Integral {5} also genau über ein Voxel und das Signal aus dem Voxel ist konstant.

Somit werden Geisterartefakte die bei Applikation des Spoilinkrements ψ alleine, also ohne Spoilergradient (d.h. $m_{sp} = 0$), entstünden, unterdrückt. Allerdings muss zu einer ausreichenden Artefaktunterdrückung nicht unbedingt $m_{sp} = 2\pi$ (oder ganzzahlige Vielfache davon) gelten, die Artefaktunterdrückung wird über eine große Breite an Spoilmomenten gewährleistet, wobei es keine Vorzugsrichtung für den Spoilergradienten gibt [5].

Kurze Beschreibung der Erfindung

Aufgabe der vorliegenden Erfindung ist es, die Effizienz des Gradientenspoilings und somit die Effizienz der Artefakt-Unterdrückung zu erhöhen.

Dies wird erfindungsgemäß auf ebenso überraschend einfache wie wirkungsvolle Weise dadurch erreicht, dass eine beliebige ein- oder mehrdimensionale Anordnung von k-Raum-Zeilen N mal identisch wiederholt wird, und dass Signale von identischen k-Raum-Zeilen gemittelt oder addiert werden.

Es erfolgt eine N-fache Mittelung oder Addition von identischen k-Raum-Zeilen, wobei die Mittelungen für eine bestimmte k-Raum-Zeile so erfolgen, dass die N Zuordnungen einer Isochromate zur Funktion M(θ) gemäß Gl. 2 äqui-

distant im Intervall [0,2π] liegen, mit dem Abstand 2π/N. D.h. es gilt für die Magnetisierung zur q-ten der N identischen k-Raum-Zeilen

$$\mathbf{M}^+_{kq}(\theta) = \mathbf{M}^+_{k1}(\theta + p2\pi/N) \qquad \{8\}$$

mit $q \in [1,N], p \in [0,N-1]$, wobei p und q ganze Zahlen sind. Es gilt nicht notwendigerweise p = q.

Beschreibung der bevorzugten Ausführungsformen

Bei einer Variante des erfindungsgemäßen Verfahrens werden vor oder zwischen den HF-Pulsen mit nachfolgender Aufnahme einer k-Raum-Zeile Blöcke von einem oder mehreren HF-Pulsen eingefügt, bei denen keine k-Raum-Zeile aufgenommen werden, der Zähler n jedoch weiterläuft. Derartige Pulsblöcke werden auch als "Dummy-Sequenzzyklen" bezeichnet.

Eine besonders vorteilhafte Variante des erfindungsgemäßen Verfahrens ist dadurch gekennzeichnet, dass zwei identische k-Raum-Zeilen m·P+P/N HF-Pulse auseinander liegen, wobei m eine natürliche Zahl oder 0 ist, und dass P und N so gewählt werden, dass P/N eine natürliche Zahl ergibt.

Bei einer weiteren Variante des erfindungsgemäßen Verfahrens wird das Verfahren über eine computergestützte Ansteuerung des Kernspintomographen aktiviert.

Das Verfahren kann etwa in ein Computerprogramm implementiert werden, das den Kernspintomographen steuert und auf das der Benutzer mittels einer Schnittstelle (User-Interface) Zugriff hat. Dadurch wäre der Benutzer in der Lage, die das Verfahren charakterisierenden Parameter (Spoilmoment in alle drei Raumrichtungen, Spoilinkrement, Anzahl der Mittelungen, k-Raum-Zeilen pro Mittelung) über die Schnittstelle einstellen zu können.

Außerdem könnte dem Benutzer eine automatische Anpassung der charakterisierenden Parameter des Verfahrens angeboten werden, die mittels einer An/Aus-Schaltung über die Benutzerschnittstelle aktiviert werden kann.

Darüber hinaus ist es vorteilhaft, wenn bei der Aktivierung des Verfahrens über die computergestützte Ansteuerung das totale Gradientenmoment automatisch um den Faktor N reduziert wird. Dabei wird das Artefaktverhalten der Aufnahme ohne Mittelungen und ohne reduzierten Spoilergradient beibehalten.

Detailbeschreibung und Zeichnungen

Es zeigen:

Fig. 1: Charakterisierende Elemente einer HF-gespoilten Gradientenechosequenz gemäß dem Stand der Technik.

Fig. 2: Magnitude der im Offresonanzwinkel θ 2π-periodischen Magnetisierung M(θ) im pseudo steady state (nach unbestimmter Anzahl von Pulsen);

Fig. 3: Beispiel, gemessen an einem Flaschenphantom, ψ = 117°. **a**) Bild aus einem k-Raum, aufgenommen mit $m_{sp} = \pi$ und 200 dummy-Sequenzzyklen vor der Aufnahme. **b**) Bild aus einem zweiten k-Raum, $m_{sp} = \pi$, 220 dummy Sequenzzyklen vor der Aufnahme. **c**) komplexe Addition beider Bilder aus a und b. Die Intensität der verbleibenden Geisterartefakte entspricht derjenigen einer einzigen Aufnahme **d**) mit $m_{sp} = 2\pi$.

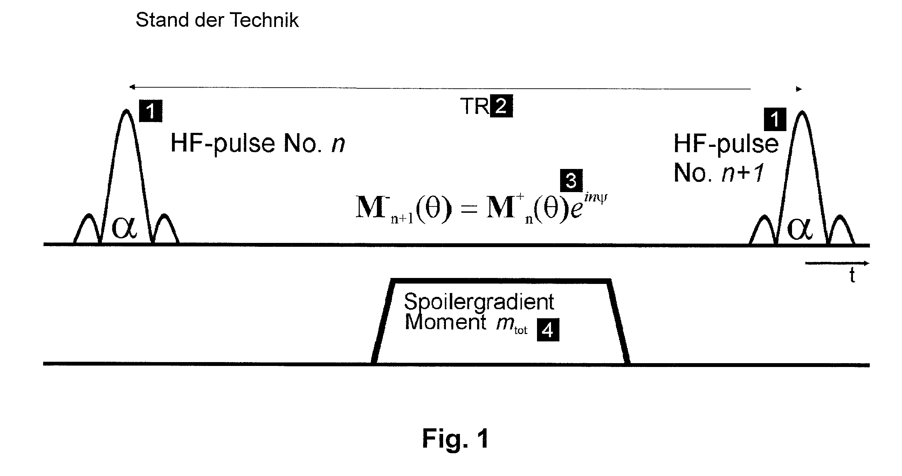

Eine typische HF-gespoilte Gradientenechosequenz ist in Fig. 1 dargestellt. In der oberen Reihe sind die HF-Pulse 1 im Abstand TR 2 mit Flipwinkel α. Zwischen den transversalen Magnetisierungsvektoren

$\mathbf{M}^+_n(\theta) = M^+_{x,n} + iM^+_{y,n}$ unmittelbar nach Puls Nr. n und $\mathbf{M}^-_{n+1}(\theta) = M^-_{x,n+1} + iM^-_{y,n+1}$ unmittelbar vor Puls Nr.

n+1 gilt also die Beziehung 3 $\mathbf{M}^-_{n+1}(\theta) = \mathbf{M}^+_n(\theta)e^{in\psi}$ .

In der unteren Reihe ist der Spoilergradient 4 mit beliebiger Richtung dargestellt.

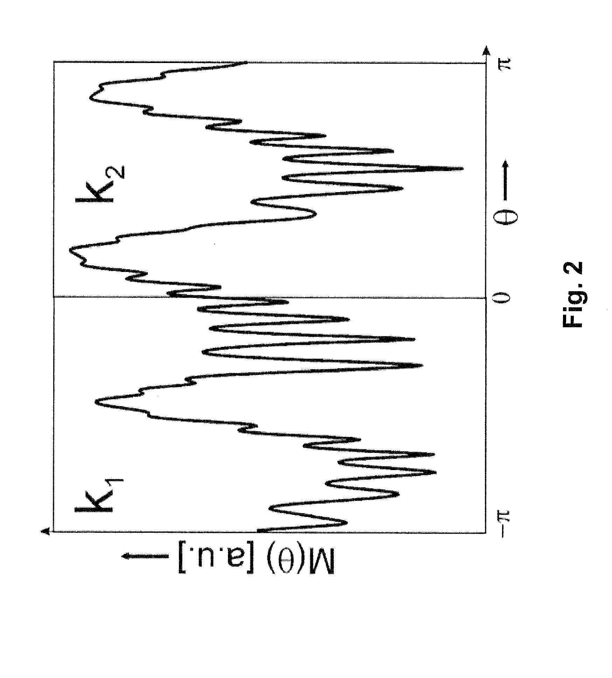

Am Beispiel von N = 2 wird die Funktionsweise des Verfahrens genauer beschrieben (siehe **Fig. 2**). Es gelte ein gängiges Spoilinkrement ψ = 117°, d.h. K = 13 und P = 40, das Spoilmoment sei $m_{sp} = \pi$.

Dann gilt entsprechend des beschriebenen Verfahrens für die Addition der Signale zweier k-Raum-Zeilen $k_1$ und $k_2$

$$s_{k1}\left(m_{sp} = \pi\right) + s_{k2}\left(m_{sp} = \pi\right)$$

$$= \int_{-\pi/2}^{\pi/2} M_n^+(\theta)d\theta + \int_{-\pi/2}^{\pi/2} M_n^+(\theta + \pi)d\theta = 2s_{k1}\left(m_{sp} = 2\pi\right) = 2\int_{-\pi}^{\pi} M_n^+(\theta)d\theta = const. \quad \{9\}$$

Das Voxelsignal einer k-Raumzeile mit $m_{sp} = 2\pi$ entspricht also der Addition zweier identischer k-Raumzeilen, die mit jeweils dem halben Spoilmoment aufgenommen wurden. Der Faktor 2 in Gl. {9} ist ein Gewichtungsfaktor, der berücksichtigt, dass im Fall der Addition jeder Kern N mal zum addierten Signal beiträgt.

Eine Bildaufnahme erfolgt nun im zweidimensionalen Fall beispielsweise in der Weise, dass zwei k-Räume mit m*P+P/N k-Raum-Zeilen unmittelbar nacheinander aufgenommen werden. Die k-Raum Trajektorie ist dabei beliebig, muss aber für beide Aufnahmen die Gleiche sein. Im Zahlenbeispiel mit m = 5, P = 40, N = 2 ergeben sich also zwei k-Räume mit jeweils 220 k-Raum-Zeilen.

Es können auch k-Räume von anderer Größe gemittelt werden, solange gewährleistet bleibt, dass identische k-Raum-Zeilen n*P+P/N Sequenzzyklen auseinander liegt. Im einfachsten Fall können Dummy-Sequenzzyklen gefahren werden, während der kein Signal aufgenommen wird, die Magnetisierung sich aber dennoch gemäß Gl. {2} verhält.

Die dargestellte Bildmatrix ist unabhängig von der Zahl der k-Raum-Zeilen, durch Interpolation können beliebige Bildmatrixgrößen erreicht werden.

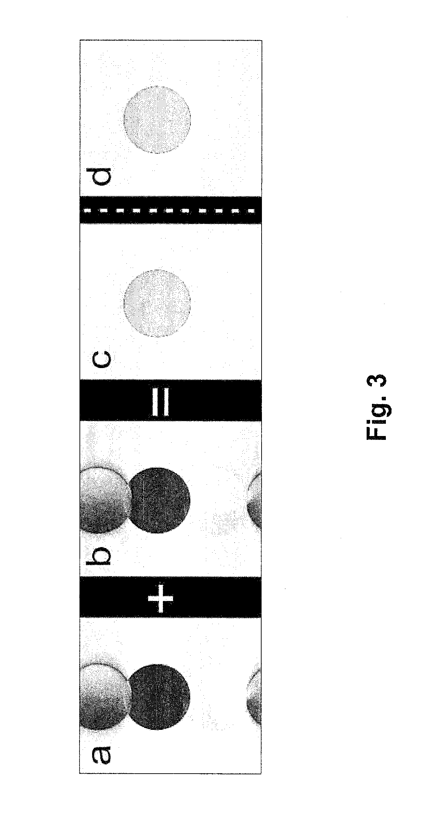

Ein Beispiel, gemessen an einem Flaschenphantom bei einer Feldstärke von 1.5T, zeigt **Fig. 3**.

Bezugszeichenliste

1 HF-Puls

2 Zeitlicher Abstand TR

3 Beziehung zwischen den Magnetisierungsvektoren

4 Spoilergradient

Literatur

1. Zur, Y., Wood, M.L., and Neuringer, L.J., Spoiling of transverse magnetization in steady-state sequences. Magn Reson Med, 1991. 21(2): p. 251-63.

2. Sobol, W.T. and Gauntt, D.M., On the stationary states in gradient echo imaging. J Magn Reson Imaging, 1996. 6(2): p. 384-98.

3. Scheffler, K., A pictorial description of steady-states in rapid magnetic resonance imaging. Concepts In Magnetic Resonance, 1999. 11(5): p. 291-304.

4. Denolin, V., Azizieh, C., and Metens, T., New insights into the mechanisms of signal formation in RF-spoiled gradient echo sequences. Magn Reson Med, 2005. 54(4): p. 937-54.

5. Leupold, J., Hennig, J., and Scheffler, K., Moment and direction of the spoiler gradient for effective artifact suppression in RF-spoiled gradient echo imaging. Magn Reson Med, 2008. 60(1): p. 119-27.

6. Crawley, A.P., Wood, M.L., and Henkelmann, R.M., Elimination of Transverse Coherences in FLASH MRI. Magn Reson Med, 1988. 8: p. 248-60.

7. Griswold, M.A., Jakob, P.M., Heidemann, R.M., Nittka, M., Jellus, V., Wang, J., Kiefer, B., and Haase, A., Generalized autocalibrating partially parallel acquisitions (GRAPPA). Magn Reson Med, 2002. 47(6): p. 1202-10.

8. Pruessmann, K.P., Weiger, M., Scheidegger, M.B., and Boesiger, P., SENSE: sensitivity encoding for fast MRI. Magn Reson Med, 1999. 42(5): p. 952-62.

**Patentansprüche**

1. Verfahren zum Betrieb eines Kernspintomographen, wobei eine kontinuierliche Folge von Hochfrequenz- (=HF) Pulsen auf eine Probe eingestrahlt wird, wobei $\Psi$ konstanter Phasenwert für alle Magnetisierungsvektoren ist, wobei alle Magnetisierungsvektoren während des n-ten Sequenzintervalls einen Phasenfortschritt $F_n=n\Psi$ erfahren, wobei P die Zahl der HF-Pulse ist, nach der sich die Phasenlage der Magnetisierungsvektoren wiederholt, wobei das totale Gradientenmoment in eine oder mehrere Raumrichtungen einen Wert größer 0 aufweist, wobei aufeinanderfolgende Pulse den konstanten zeitlichen Abstand TR aufweisen und wobei nach der Einstrahlung eines HF-Pulses eine k-Raum-Zeile aufgenommen wird;
   **dadurch gekennzeichnet,**
   **dass** eine beliebige ein- oder mehrdimensionale Anordnung von k-Raum-Zeilen N mal identisch wiederholt wird, und
   **dass** Signale von identischen k-Raum-Zeilen gemittelt oder addiert werden.

2. Verfahren nach Anspruch 1, **dadurch gekennzeichnet, dass** vor oder zwischen den HF-Pulsen mit nachfolgender Aufnahme einer k-Raum-Zeile Blöcke von einem oder mehreren HF-Pulsen eingefügt werden, bei denen keine k-Raum-Zeile aufgenommen wird, der Zähler n jedoch weiterläuft.

3. Verfahren nach einem der vorhergehenden Ansprüche, **dadurch gekennzeichnet, dass** zwei identische k-Raum-Zeilen m.P+P/N HF-Pulse auseinander liegen, wobei m eine natürliche Zahl oder 0 ist, und dass P und N so gewählt werden, dass P/N eine natürliche Zahl ergibt.

4. Verfahren nach einem der vorhergehenden Ansprüche, **dadurch gekennzeichnet, dass** das Verfahren über eine computergestützte Ansteuerung des Kernspintomographen aktiviert wird.

5. Verfahren nach Anspruch 3, **dadurch gekennzeichnet, dass** bei der Aktivierung des Verfahrens über die computergestützte Ansteuerung das totale Gradientenmoment automatisch um den Faktor N reduziert wird.

Fig. 1

EP 2 372 384 A1

Fig. 2

Fig. 3

Europäisches
Patentamt

European
Patent Office

Office européen
des brevets

## EUROPÄISCHER RECHERCHENBERICHT

Nummer der Anmeldung

EP 10 15 8005

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| T | J.LEUPOLD ET AL.: "Increasing Spoiling Efficiency in RF-Spoiled Gradient Echo Sequences by Averaging of Phase-Cycle Adapted k-Spaces" PROC.INTL.SOC.MAG.RESON.MED., 1. Mai 2010 (2010-05-01), Seite 2379, XP002590944 * das ganze Dokument * | 1-5 | INV. G01R33/561 |
| X,D | J.LEUPOLD ET AL.: "Moment and Direction of the Spoiler Gradient for Effective Artifact Suppression in RF-Spoiled Gradient Echo Imaging" MAGNETIC RESONANCE IN MEDICINE, Bd. 60, 2008, Seiten 119-127, XP002590945 * das ganze Dokument * | 1-5 | |
| X | W.LIN ET AL.: "Improved Signal Spoiling in Fast Radial Gradient-Echo Imaging: Applied to Accurate T1 Mapping and Flip Angle Correction" MAGNETIC RESONANCE IN MEDICINE, Bd. 62, 2009, Seiten 1185-1194, XP002590946 * das ganze Dokument * | 1-5 | RECHERCHIERTE SACHGEBIETE (IPC) G01R |
| X,D | V.DENOLIN ET AL.: "New Insights Into the Mechanisms of Signal Formation in RF-Spoiled Gradient Echo Sequences" MAGNETIC RESONANCE IN MEDICINE, Bd. 54, 2005, Seiten 937-954, XP002590947 * das ganze Dokument * | 1-5 | |

Der vorliegende Recherchenbericht wurde für alle Patentansprüche erstellt

| Recherchenort | Abschlußdatum der Recherche | Prüfer |
|---|---|---|
| München | 8. Juli 2010 | Lersch, Wilhelm |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

.......................................................................................................

& : Mitglied der gleichen Patentfamilie, übereinstimmendes
Dokument

EPO FORM 1503 03.82 (P04C03)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **ZUR, Y. ; WOOD, M.L. ; NEURINGER, L.J.** Spoiling of transverse magnetization in steady-state sequences. *Magn Reson Med,* 1991, vol. 21 (2), 251-63
- **SOBOL, W.T. ; GAUNTT, D.M.** On the stationary states in gradient echo imaging. *J Magn Reson Imaging,* 1996, vol. 6 (2), 384-98
- **SCHEFFLER, K.** A pictorial description of steady-states in rapid magnetic resonance imaging. *Concepts In Magnetic Resonance,* 1999, vol. 11 (5), 291-304
- **DENOLIN, V. ; AZIZIEH, C. ; METENS, T.** New insights into the mechanisms of signal formation in RF-spoiled gradient echo sequences. *Magn Reson Med,* 2005, vol. 54 (4), 937-54

- **LEUPOLD, J. ; HENNIG, J. ; SCHEFFLER, K.** Moment and direction of the spoiler gradient for effective artifact suppression in RF-spoiled gradient echo imaging. *Magn Reson Med,* 2008, vol. 60 (1), 119-27
- **CRAWLEY, A.P. ; WOOD, M.L. ; HENKELMANN, R.M.** Elimination of Transverse Coherences in FLASH MRI. *Magn Reson Med,* 1988, vol. 8, 248-60
- **GRISWOLD, M.A. ; JAKOB, P.M. ; HEIDEMANN, R.M. ; NITTKA, M. ; JELLUS, V. ; WANG, J. ; KIEFER, B. ; HAASE, A.** Generalized autocalibrating partially parallel acquisitions (GRAPPA). *Magn Reson Med,* 2002, vol. 47 (6), 1202-10
- **PRUESSMANN, K.P. ; WEIGER, M. ; SCHEIDEGGER, M.B. ; BOESIGER, P.** SENSE: sensitivity encoding for fast MRI. *Magn Reson Med,* 1999, vol. 42 (5), 952-62